(19) Europäisches Patentamt

European Patent Office

Office européen des brevets

(11) **EP 3 036 550 B1**

(12) **EUROPEAN PATENT SPECIFICATION**

(45) Date of publication and mention
of the grant of the patent:
**11.05.2022  Bulletin 2022/19**

(21) Application number: **14836412.8**

(22) Date of filing: **15.08.2014**

(51) International Patent Classification (IPC):
*G01R 23/02* (2006.01)          *G01R 21/00* (2006.01)
*G01R 19/00* (2006.01)          *G01R 19/25* (2006.01)
*G01R 23/15* (2006.01)

(52) Cooperative Patent Classification (CPC):
**G01R 19/0007; G01R 19/2513; G01R 23/15**

(86) International application number:
**PCT/FI2014/050628**

(87) International publication number:
**WO 2015/022451 (19.02.2015 Gazette 2015/07)**

(54) **METHOD AND SYSTEM AND COMPUTER PROGRAM FOR MEASURING ALTERNATING-CURRENT SYSTEM QUANTITIES**

VERFAHREN UND SYSTEM SOWIE COMPUTERPROGRAMM ZUR MESSUNG VON WECHSELSTROMGRÖSSEN

PROCÉDÉ ET SYSTÈME ET PROGRAMME INFORMATIQUE PERMETTANT DE MESURER DES QUANTITÉS DE SYSTÈMES DE COURANT ALTERNATIF

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **16.08.2013  FI 20135835**

(43) Date of publication of application:
**29.06.2016  Bulletin 2016/26**

(73) Proprietor: **Arcteq Relays Oy
65300 Vaasa (FI)**

(72) Inventor: **VIRTALA, Tero
FI-65370 Vaasa (FI)**

(74) Representative: **Kespat Oy
Vasarakatu 1
40320 Jyväskylä (FI)**

(56) References cited:
EP-A1- 1 936 391          EP-A2- 2 306 208
CN-A- 103 063 913        US-A- 5 014 229
US-A- 5 151 866          US-A- 5 406 495
US-A- 5 832 414          US-A1- 2004 186 669
US-A1- 2012 310 569

**Description**

The present invention relates to a method for measuring alternating-current system quantities through measurement connections producing frequency-dependent errors according to the preamble of claim 1.

The invention also relates to a corresponding system and computer program for implementing the method.

Though the invention generally concerns 3-phase systems, it can also be applied in single-phase electrical systems.

The frequency measurement of electric-power networks is an important part of the monitoring and control of an electric-power network. Many different frequency protections and control automation are based on the use of frequency measurement. On the basis of frequency measurement various electric-power network components can be protected from overloading and detrimental frequencies. In addition, frequency measurement can be used as a basis for controlling generators. Frequency measurement is also used for power and energy calculation, on which the selling and buying of electricity are based.

Various frequency meters are known from the prior art, which convert the current and voltage signals of an electric-power network into phase angle and magnitude, using so-called Fourier transformation, particularly FFT (Fast Fourier Transform) calculation. Wavelet analysis can also be used. Stated generally, periodic signals are examined using the chosen frequency analysis. The analog signal is sampled at a specific constant frequency through the measurement range.

The problem with such a technique is that it does not take into account the measurement error created by frequency differences. If the sampling frequency is, for example, a fixed 50 Hz, and the measured voltage of the electric-power network is 60 Hz, the magnitude of the measurement error will be already about 5 % in the different phases of the current.

Patent publication US 5,014,229 presents method comprising sampling of an analog signal, calculating plurality of harmonic signals, correction of each harmonic signal and finally combining harmonic signals to one calibrated signal. Correction tables for each harmonic frequency are used. The tables contain non-linearity amplitude and phase shift correction curves.

Patent publication US 5,832, 414 presents a method compensating for errors in phasor estimation due to oscillations caused by discrete fourier transforms used to estimate signal frequency.

Patent publication US 5,151,866 presents a method rapidly and continuously sampling AV voltage and current signals. The deviation from sine signal is detected in a zero-crossing point.

Patent publication US 8,108,165 B2 is known from the prior art and discloses one frequency meter, which uses frequency-dependent sampling of analog signals. Frequency-dependent sampling is used over the entire measurement range of 6 - 75 Hz (more generally 5 - 100 Hz). If the measured frequency is outside the measurement range, the lowest or highest sampling frequency and a correction factor, which seeks to compensate for the error, are used in the measurement. Despite the frequency-dependent sampling, considerable measurement errors appear in frequency measurement of this kind, as the measurement does not take into account the error caused by the components of the measurement card.

The invention is intended to create a method that is more accurate and reliable than methods of the prior art for measuring frequency in an electric-power network. The characteristic features of the method according to the present invention are stated in the accompanying Claim 1 and the features of the system applying the method are stated in Claim 9. As, according to the invention, the non-linearity of the analog component of each measurement connection is calibrated at different frequencies and a frequency-dependent correction function is created, the method according to the invention gives an extremely accurate result over a wide frequency range. The frequency-dependent correction is preferably made to the magnitude and phase-angle values of several frequency components. The correction function is preferably a matrix, in the elements corresponding to a specific input are the correction values for discrete frequencies. These can be used in a stepped manner, but it is preferable to interpolate the intermediate values. Extreme values can be used outside the nominal frequency range.

The magnitude and/or phase-angle values are preferably calculated for 7 - 64, preferably 15 - 31 harmonic frequency components.

In one embodiment, the device is calibrated magnitudedependently and a similar correction table is created. The actual correction calculation is entirely the same as that described in connection with the frequency-dependent correction table.

In the following, the invention is described in detail with reference to the accompanying drawings depicting some embodiments of the invention, in which

Figure 1          shows the wiring of the protection device in monitoring a 3-phase feeder line,

Figure 2          shows the analog measurement connections of five current-measurement channels on a special analog card,

| Figure 3 | shows the conversion of values obtained from an A/D converter into current values, |
| Figure 4 | shows a general view of the processing of each sequence, |
| Figure 5 | shows the correction to be made for each frequency component, |
| Figures 6, 7, and 8 | show the programmatic updating arrangement of five correction tables of a current-measurement channel, |
| Figure 9a | shows the error of a known measurement as a function of frequency, |
| Figure 9b | shows the error of frequency measurement according to the invention using 3-phase currents, |
| Figure 10 | shows a flow diagram of an example of the frequency correction of voltage measurement, |
| Figure 11 | shows a flow diagram of a main program initiating the re-calculation of a correction table, |
| Figure 12 | shows a flow diagram of the re-calculation. |

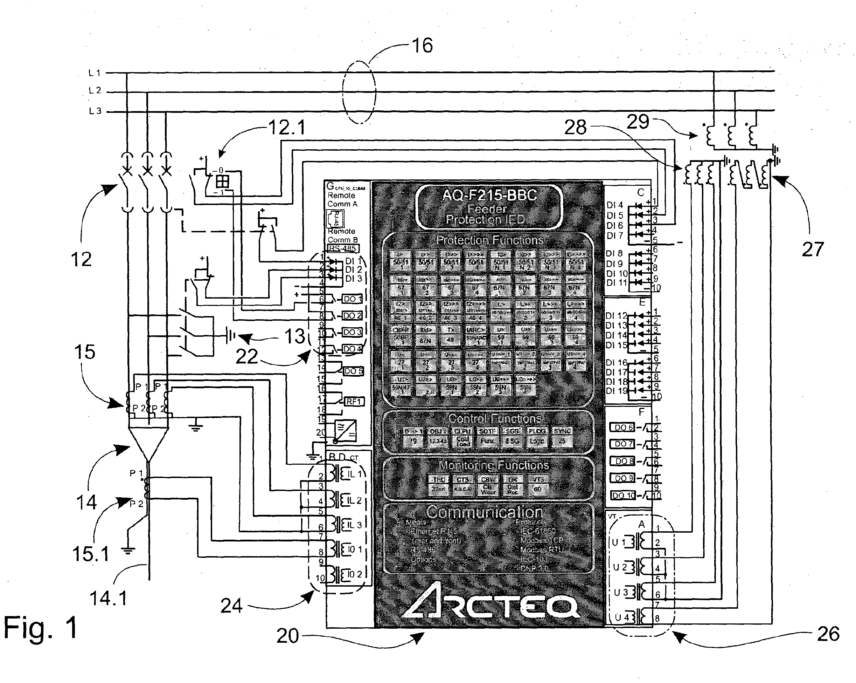

The protection device 20 of Figure 1 monitors a branch line, which is connected to a cable terminal 14, connected to the main line 16. Feed to the branch line, which is depicted by the cable terminal 14, is taken from the phases L1, L2, L3 of the main line 16. The branch line is protected by a 3-phase circuit breaker 12 and an earthing switch 13. The circuit breaker 12 is controlled by a smart protecting device 20. This can measure the voltage inputs U1 - U4, and current inputs IL1 - IL3, I01 and 102. The operating device of the 3-phase circuit breaker 12, and the state detector of the earthing switch 13 are connected to the outputs D01 - D04 of the I/O component 22. The earthing switch 13 is manually operated, but state data are taken from it through the I/O component 22 to the protection device 20, which prevents the circuit breaker 12 from closing, if the earthing is switched on.

Voltage detection uses a common star-connected primary-coil series 29. The voltage inputs U1 - U3 (phase voltages) use a star-connected secondary-coil series 28 and the zero voltage to the voltage input U4 is formed by the open-delta connection 27 of the voltage converters. The voltages are taken to the voltage-checking converters 26 of the protection device.

The current detection IL1, IL2, IL3 of the phases of the feed line uses inductively connected coils 15 in each phase conductor. In addition, the current I01 of the earth conductor of the cable terminal is detected by means of a coil 15.1. In this case, the current input 102 is not in use. The current measurements are taken to the current-measurement transformer 24.

A precondition of first-class operation is the precise measurement of the phase quantities, which, when the frequency varies, is challenging, because conventional measurement electronics only operate well at the nominal frequency, for example, 50 Hz.

The input of the current and voltage measurements consists of analog components, which may have a considerable divergence in electrical properties, particularly farther from the nominal frequency.

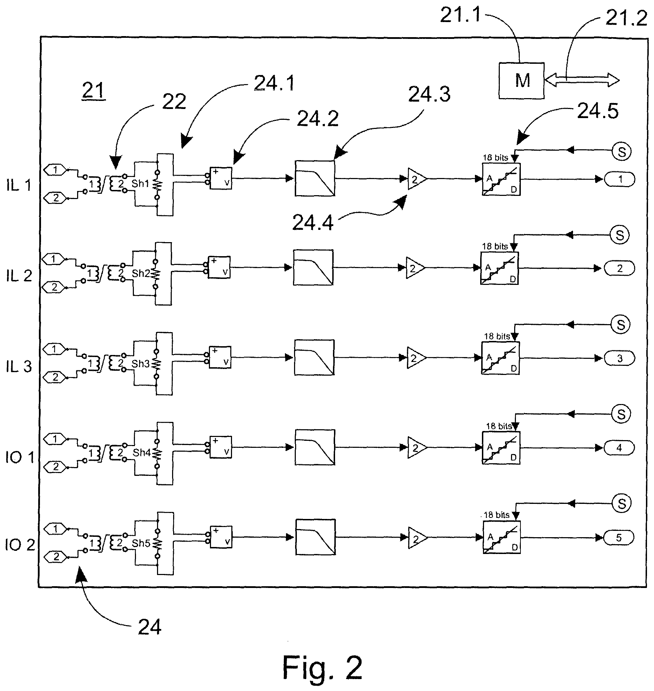

Figure 2 shows the configuration of the current-measurements' inputs as far as the A/D converter. The four voltage-measurement chains are in a corresponding manner on a different card (not shown). All the analog components are installed on a special replaceable circuit card 21, in which there is also a non-volatile memory 21.1 and its connection means 21.2. The significance of this memory will become apparent later. The analog components, including the A/D converter, in each measurement circuit form a main non-linearity. In the chain from left to right are: a current transformer 22, a shunt resistance 'Sh$_x$' 24.1, voltage divider resistances 24.2, an analog filter 24.3, an amplifier 24.4, and finally the A/D converter 24.5 itself. The same is also true of the voltage-measurement circuits (not shown).

Each analog signal is sampled at the A/D converter at a multiple of the approximately measured frequency $f_m$ (6 - 75 Hz, tolerance about 100 mHz) creating a base series depicting the period in such a way that the samples of the period form a fundamental-wave length FFT buffer for each measurement channel of essentially one entire electrical period (e.g, the fundamental wave of a 50-Hz electrical period is 20 ms). The A/D converter is controlled by a sampling signal S brought from the host processor, the frequency of which $f_s$ is adjusted according to the approximately measured base frequency $f_m$, preferably using the equation:

$$f_s = f_m \times \text{number of samples of the FFT buffer.}$$

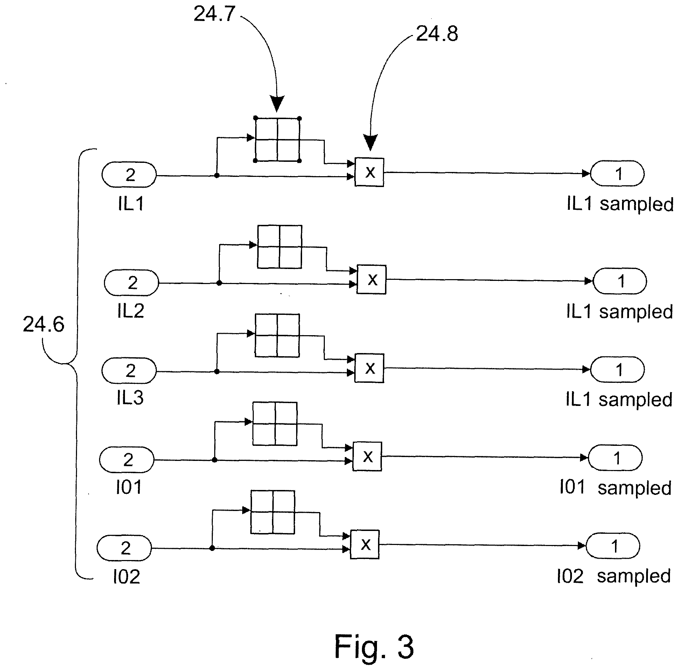

Figures 3 - 8 show schematically software implementations of the calculation.

Figure 3 shows the conversion of raw values 24.6 obtained from the A/D converter into current values. The A/D converter's reading range -132000...+132000 corresponds, for example, to a current range of 0...100 A. The conversion takes place by fetching from a lookup table 24.7 a channel-specific scaling factor, which is taken together with the value to a multiplier 24.8. This is not important in terms of the invention.

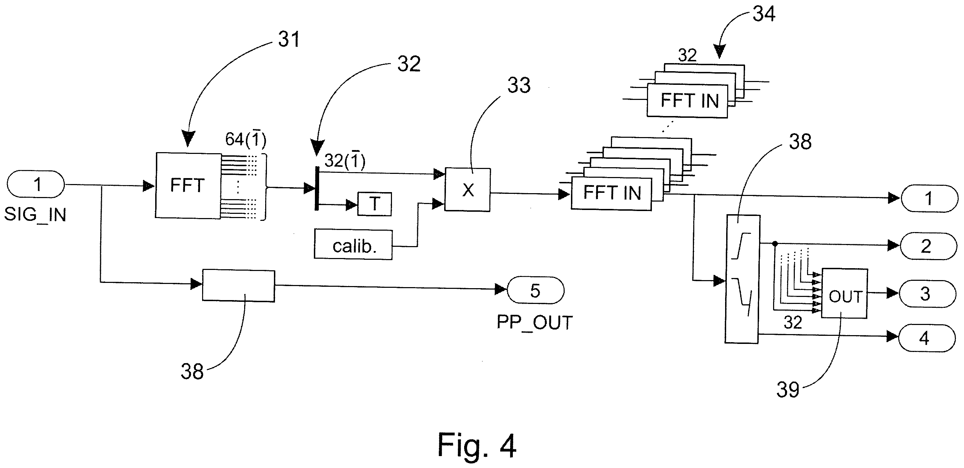

In Figure 4, each channels' base series, i.e. the FFT buffer, is taken to FFT transformation 31, which calculates, in addition to the base frequency 31, the root-mean-square RMS of the magnitude and the phase angle of the harmonic frequency component. From the FFT calculation 31 are obtained 64 vectors, 32 of which are mirror images, which are terminated at the selector 32. Figure 4 mainly follows the processing of a single frequency component. Here, FFT computation is an effective numerical form of calculation for performing Fourier analysis. The Wavelet technique would provide advantages in the calculation of offset currents and impedance protectors. The necessary frequency analysis can also be made using some other method.

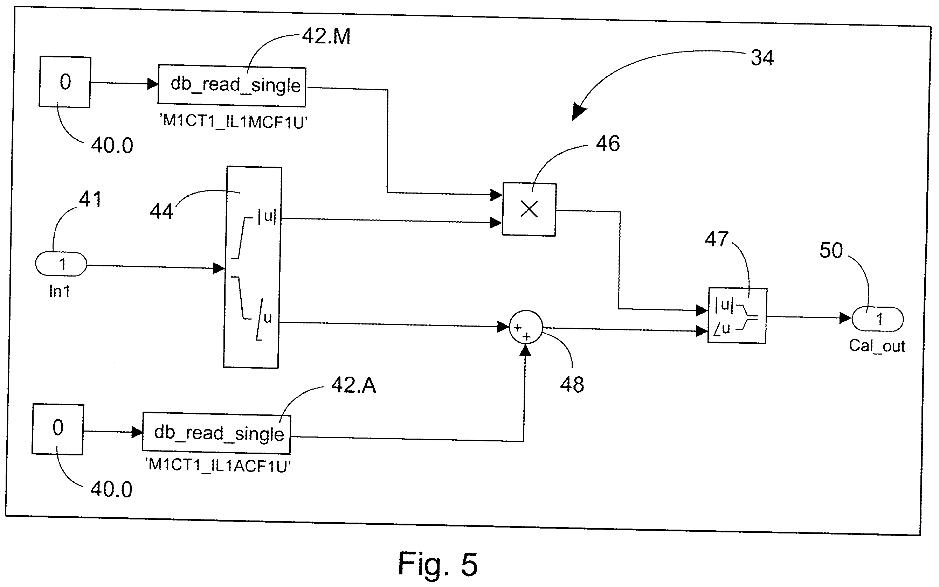

The 32 vectors selected for further processing are scaled to form root-mean-square values in the multiplier 33 (complex vector x (sqrt(2) / number of samples)). After this, the vector of each frequency component (in this case current) is taken to the calibration correction module 34, which is shown in greater detail in Figure 5. As result, the calibrated vector (output 1)of each frequency component is obtained. From this, a separate magnitude value (output 2) and phase angle (output 4) is formed by a cartesian converter 38. A precise true-root-mean-square value TRMS (output 3) is formed in the calculator 39 from the magnitude values of all the frequency components. It is obtained by taking the square root of the sum of the squares of the magnitude values (32 items).

An approximate maximum value (output 5), which can be used for the approximate adjustment of later stages, for example, is formed from the uncalibrated input signal by the calculator 38.

Figure 5 shows the operation of the said calibrationcorrection module 34, which is essential to the present invention. The vector (e.g., 100 V, j100 V) obtained from the input 41 is divided by the cartesian converter 44 into separate magnitude and phase-angle values (|142 V|, ∠45°), for which a separate calibration correction is made with the aid of pre-calculated frequency-dependent correction factors. In the case of Figure 5, the processing is base-frequency correction, because the correction factor is read at the clock pulse 0. The vector's first correction factor is 40.0. The channel-specific magnitude correction factor is read from the registry 42.M 'M1CT1_ IL1MCF1U' (channel IL1) and is taken to the multiplier 46, in which it is multiplied by the measured value. Correspondingly, the channel-specific phase-angle correction factor is read from the registry 42.A 'M1CT1_ IL1ACF1U' (channel IL1) and taken to the summer 48, where it is summed with the retrieved phase angle. Finally, the calibrated values obtained are converted back to vector values by polar conversion and sent to the output 50 'Cal_out' .

Calibration corrections according to Figure 5 are made on each channel (5 current and 4 voltage-measurement channels) and in each of these for each frequency component (32 items). Calibration coefficients, which are applied to discrete frequencies, and which are obtained in special calibration calculation, are stored in the memory 21.1 (Figure 2) of the circuit card 21. From there, they are retrieved for use by the host processor, which calculates momentary values corresponding to the frequency in the said registries 42.M and 42.A (in this case M1CT1_IL1MCF1U and M1CT1_IL1ACF1U). As the calibrated correction factors are stored in the circuit card's memory 21.1, it can be changed rapidly and the new circuit card together with the stored correction matrices will provide accurate results immediately.

By calibrating the magnitude and phase angle of the harmonic frequency components, TRMS (True Root Mean Square), the measurements using the different harmonic components and depending on multiple frequencies become accurate, which would otherwise depend entirely on the properties of the available measurement techniques, especially at higher harmonic frequencies. The measurement technique typically measures accurately only at the fixed frequency of the fundamental wave.

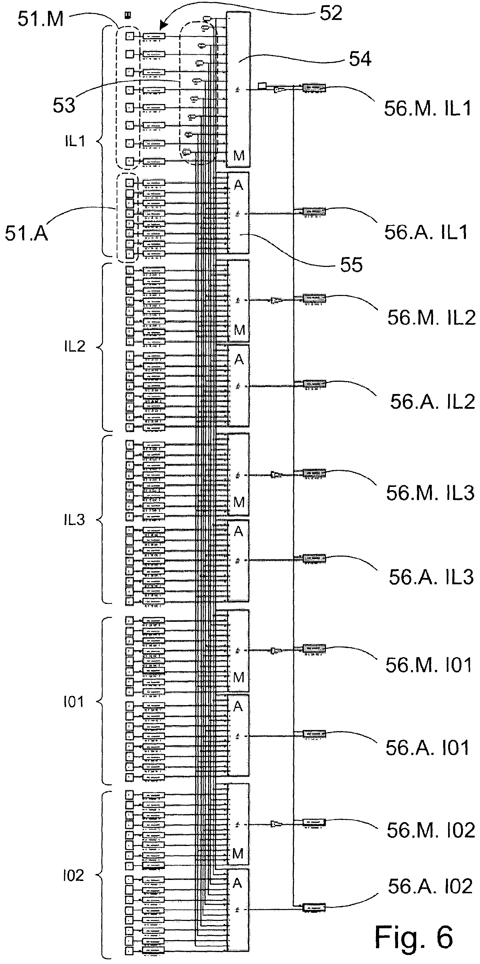

Figures 6, 7, and 8 show the software updating of the correction factors of the current measurements IL1, IL2, IL3, I01, and 102 according to the frequency at the time.

Corresponding calculation is made in the case of voltage measurement. The system's host processor includes a CPU, RAM/ROM memories, and I/O means, as well as an operating system for running the computation software.

Each current input has separate magnitude and phase-angle correction tables. The momentary calibration values for each channel are stored in registries 52. Controlled by the clock pulse, the outputs 51.M (magnitude) and 51.A (phase angle) read the momentary discrete correction values Y1 - Y8 to the approximation calculation modules 54 and 55 (magnitude and phase angles separately, on all channels). The same clock pulse controls the reading of the discrete frequency values (6, 15, 25, 30, 40, 50, 60, and 75 Hz), with which the calibration is made, for all the calculation modules 54, 55 together to the outputs X1 - X8 of the various calculation modules. The calibrated factors Y1 - Y8 are retrieved from their own, channel-specific column in Table 1. This is calculated on all the current-measurement channels IL1 - IL3, IL01, and IL02. The factors are calculated by the linear approximation from these momentary correction values using the following procedure:

X=[X1, X2, X3, X4, X5, X6, X7, X8]; the frequency-dependence factor is an 8-place vector (discrete frequencies 6 - 75 Hz);

Y=[Y1, Y2, Y3, Y4, Y5, Y6, Y7, Y8]; the magnitude or phase-angle correction factor is an 8-place vector, in which there are factors corresponding to the discrete frequencies;

The discrete frequency X(i) immediately below the measured frequency 'freq' and the corresponding factor Y(i) are sought. The correction value is freqk = (Y(i) + ((freq-X(i)) * ((Y(i + 1) - Y(i)) / (X(i + 1) - X(i))))).

The extreme values Y1 and Y8 of the factors are used above and below the discrete frequencies. The calculated factor is taken to the magnitude/phase-angle registry of the corresponding channel, e.g., the magnitude correction factor of the channel IL1 to the registry M1CT1_IL1MCF1_1' (56.M.IL1).

The analog front-end design has a considerable effect on the number of the calibration frequencies required and their selection. If the design is not linear, the desired accuracy can be achieved by increasing the number of calibration points. Similarly, a linear approximation between the discrete points is not necessarily required, if there is a sufficiently large number of discrete points.

In the following is an example of a correction table, in which there are the magnitude and angle correction values of different current-measurement channels IL1, IL2, IL3, I01, and 102 at the discrete frequencies 6 - 75 Hz (8 items).

Table 1

| freq [Hz] | IL1Cf | IL2Cf | IL3Cf | I01Cf | I02Cf |
|---|---|---|---|---|---|
| 6 | 1.00870 | 1.00855 | 1.00673 | 0.90746 | 0.86719 |
| 15 | 1.00758 | 1.00756 | 1.00554 | 0.94732 | 0.90845 |
| 25 | 1.00758 | 1.00776 | 1.00565 | 0.98543 | 0.97558 |
| 30 | 1.00763 | 1.00774 | 1.00569 | 0.98928 | 0.98439 |
| 40 | 1.00842 | 1.00855 | 1.00617 | 0.98968 | 0.98666 |
| 50 | 1.00832 | 1.00836 | 1.00634 | 0.99051 | 0.98772 |
| 60 | 1.00815 | 1.00836 | 1.00573 | 0.99094 | 0.98884 |
| 75 | 1.00773 | 1.00802 | 1.00579 | 0.99111 | 0.98925 |
|  |  |  |  |  |  |
| freq [Hz] | IL2ang | IL3ang | I01ang | I02ang |  |
| 6 | -0.03 | 0.00 | -4.63 | -4.23 |  |
| 15 | -0.02 | 0.00 | -2.53 | -2.70 |  |
| 25 | -0.01 | 0.00 | -0.88 | -1.28 |  |
| 30 | -116.94 | -0.02 | -0.42 | -0.69 |  |
| 40 | 20.52 | 0.01 | -0.28 | -0.47 |  |
| 50 | 0.00 | 0.00 | -0.18 | -0.32 |  |
| 60 | -0.01 | 0.00 | -0.12 | -0.25 |  |
| 75 | -0.01 | 0.00 | -0.11 | -0.19 |  |

The angle value of channel IL1 acts as a reference for the angle values of the other channels.

These values are stored in the card's memory 21, from where they are read to the processor's RAM memory in connection with the initialization relating to starting the device.

Table 1 shows the application's calibrated frequency-dependent function k(fn), with the aid of which each measurement connection the said error is eliminated.

In the calculation model of Figures 6 - 8, the momentary values according to each frequency are picked from this table to the calculation registries, by which the measurement values are then calibrated. The calculation registries are updated according to selected criterion.

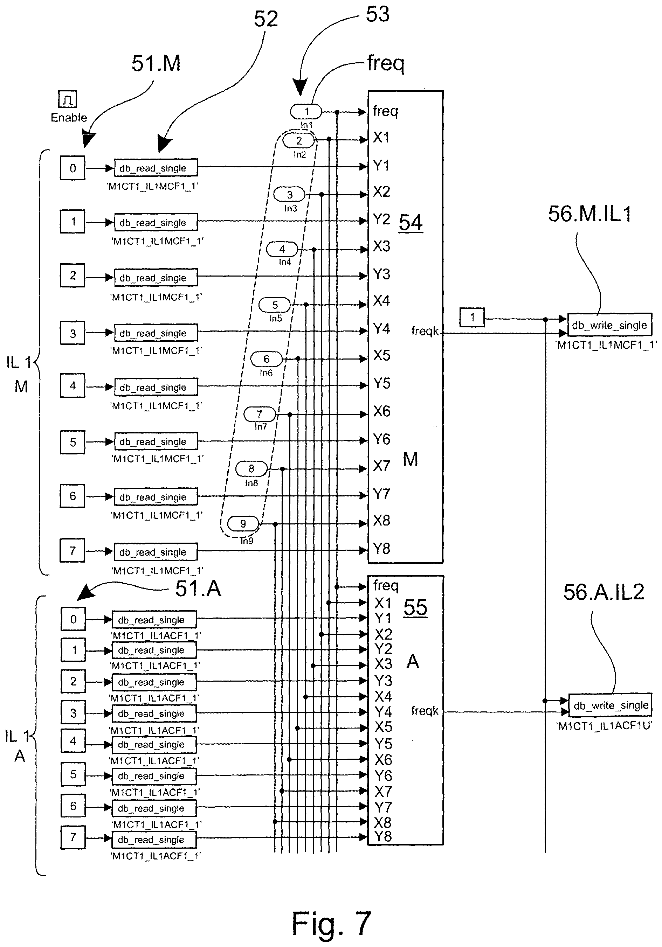

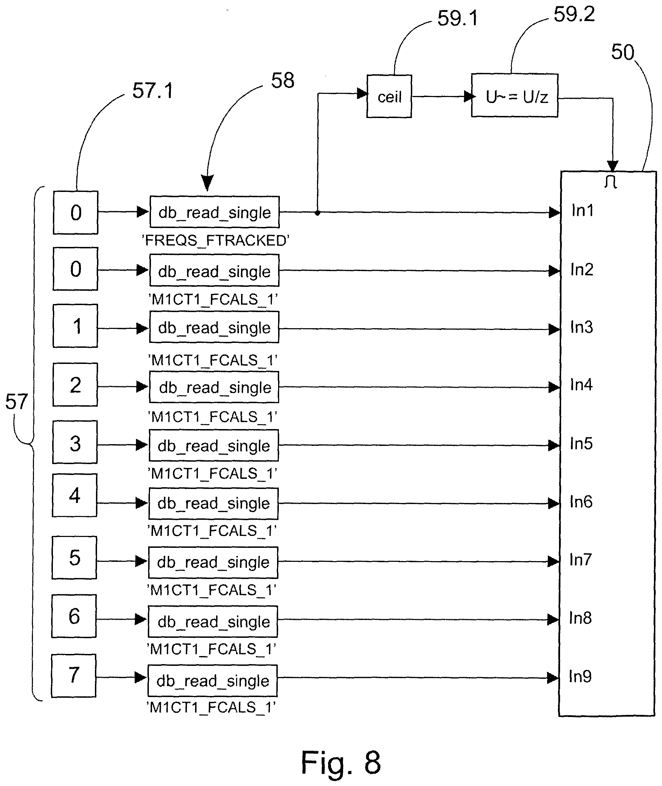

According to Figure 8, the approximately measured frequency in Herz is rounded by the unit 59.1 (cell-function) to an integer. The condition module 59.2 triggers a new calculation, if the measured frequency has changed by at least 1 Hz from the previous 5-ms round of calculation. The block 50 contains the functions of Figures 6 and 7. The memory-location readings 57 shown in Figure 8 depict the predefined calibration frequency points.

In general, the core of the system is a computer program, which comprises program code for implementing the method described.

The apparent output is calculated using the, as such, known equation:

$$\overline{S}_{L1Fund} = \overline{U}_{L1Fund} \times \overline{conj(I_{L1Fund})},$$

*inwhich*

$$\overline{U}_{L1h(1)} = \mathrm{Re}_{U_{L1h(1)}} + j\mathrm{Im}_{U_{L1h(1)}}$$

*and*

$$\overline{I}_{L1h(1)} = \mathrm{Re}_{I_{L1h(1)}} + \mathrm{Im}_{I_{L1h(1)}}$$

From this the effective output and reactive output are calculated using the equations:

$$\overline{S}_{3PH} = \left(\overline{S}_{L1Fund} + \overline{S}_{L2Fund} + \overline{S}_{L3Fund}\right)$$

$$\overline{P}_{3PH} = real\left(\overline{S}_{3PH}\right)$$

$$\overline{Q}_{3PH} = imag\left(\overline{S}_{3PH}\right)$$

Accurate calculation requires also taking the harmonic frequency components into account, in which case the apparent output of each phase is calculated as the sum of the frequency components, as follows:

$$\overline{S}_{L1} = \left(\overline{U}_{L1Fund} \times \overline{conj(I_{L1Fund})}\right) + \left(\overline{U}_{L1h(1)} \times \overline{conj(I_{L1h1})}\right) + \cdots$$

$$+ \left(\overline{U}_{L1hn} \times \overline{conj(I_{L1hn})}\right)$$

After this, the aforementioned effective-output and reactiveoutput equations can be applied.

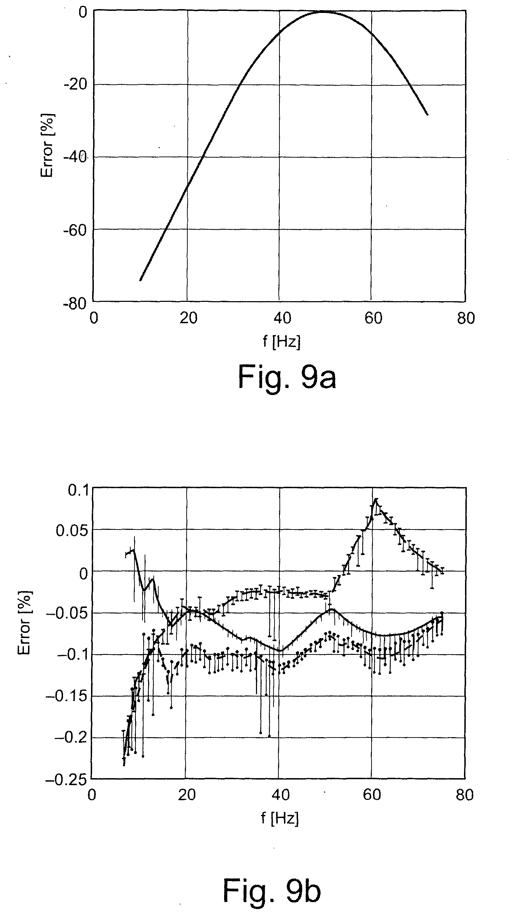

According to Figures 9a and 9b, the calculation system according to the invention provides significant frequency stability. According to Figure 9a, the conventional measurement technique for phase quantities is accurate only at the nominal frequency, in this case 50 Hz. The error in the range 6 - 75 Hz can be as much as tens of percent. Generally, the error is greater the farther one goes from the nominal frequency and the larger the multiple frequency that is being examined.

The errors of the measurement card according to the invention, for example, at different phase currents, are, according to Figure 9b, less than 0.25 % over the entire frequency range (6 - 75 Hz).

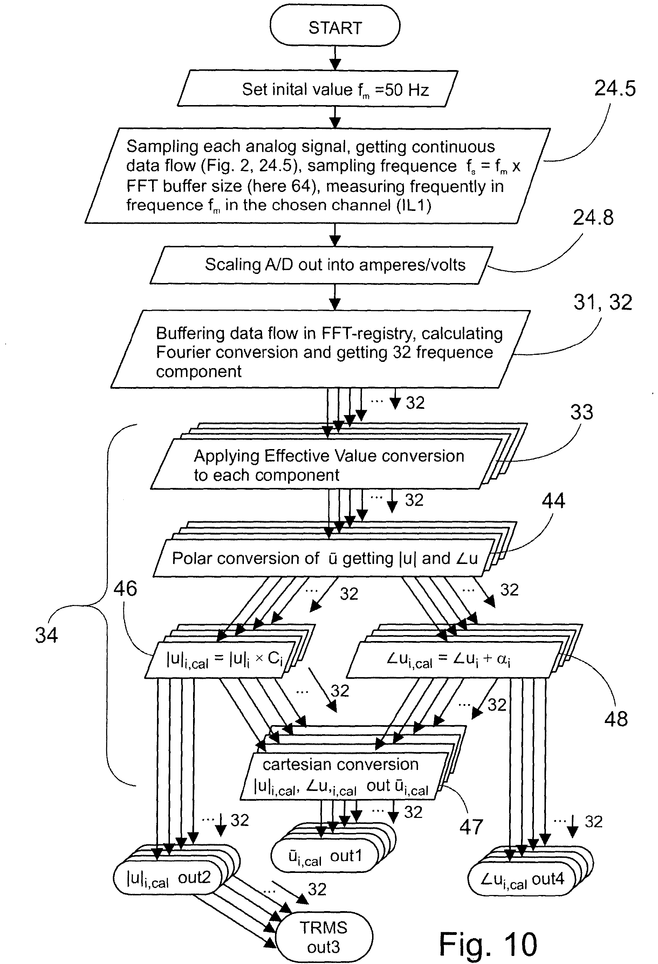

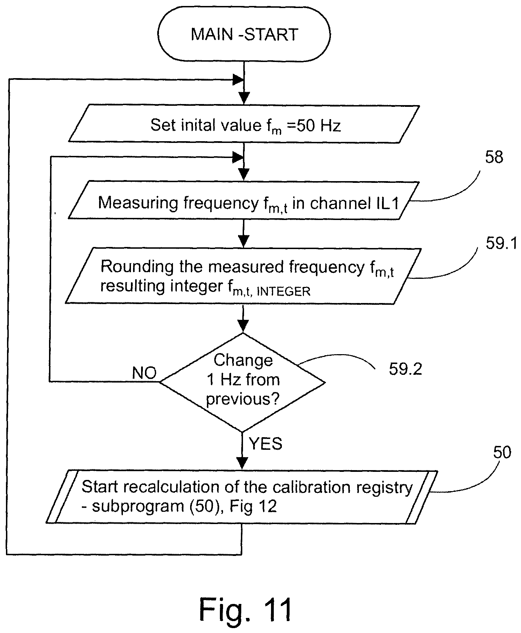

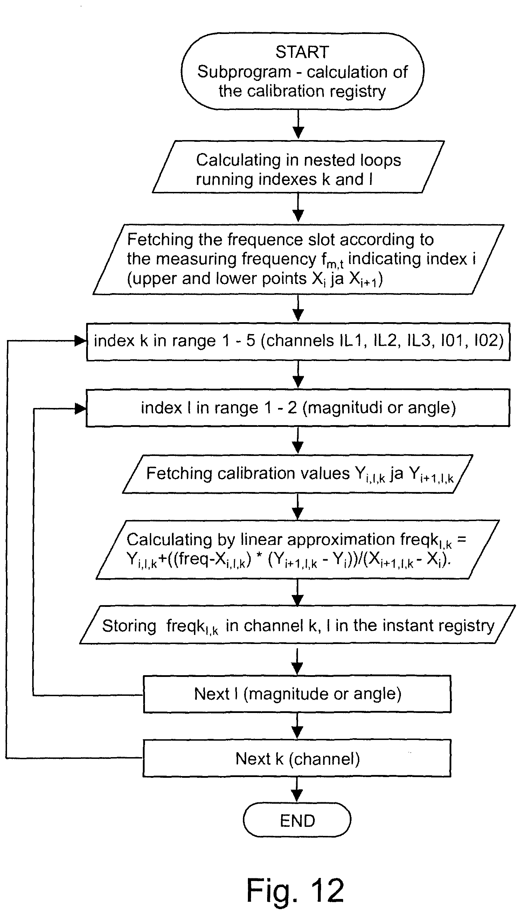

Figure 10 shows the measurement procedure of Figures 2, 3, 4, and 5 as a flow diagram (here the voltage u is being measured). The momentary correction values are marked with the quantities 'C$_i$' (46) and 'α$_i$' (48). In the software implementation, the challenge is the large number of realtime calculations, because each separate sampled measurement vector is divided, in this case, into 32 separate vectors, on which a polar conversion is performed, so that there are 64 values to be corrected in each period. The processor operates in 5-ms periods, so that there are 115 200 correction calculations (46, 48) per second in nine channels. The computing power of the prototype system is 300 Megaflops, which is more than enough for the calculation. When the frequency changes, the correction registry must be recalculated (Figures 6, 7, and 8, as well as the flow diagrams of Figures 11 and 12), so that Fourier or similar transformation must be carried out on the data flow of each channel, and the number of calculation operations required continues to increase. Thus, a frequency tolerance of 1 Hz (generally 0.4 - 2.5 Hz) has been observed to be optimal in terms of accuracy and computational capacity.

This recalculation of the calibration registry is shown as a flow diagram in Figures 11 and 12, corresponding to the different kind of graphical presentation in Figures 6 - 8. The momentary frequency is read (58) and the value is rounded to an integer (59.1), after which it is compared with the previous value (59.2), in which there is the condition 'Is there a change of at least 1 Hz from the previous?', and performance of the program continues, either as a loop directly through a preset delay to measurement of the frequency (NO), or to the recalculation procedure (50), Figure 12.

From the flow diagram of the recalculation procedure (Figure 12), it can be seen that three indices (i, k, 1) and two nested loops are required in the calculation. If the measured frequency is, for example, 41.5 Hz, it lies between 40 Hz ($X_4$) and 50 Hz ($X_5$), when the index I = 4 and the element ($Y_{4, \, 1, \, k}$ and $Y_{5, \, 1, \, k}$) is taken from each calibration table 4. and 5. to the linear approximation.

**Claims**

1. Method for measuring alternating-current system quantities through measurement channels producing frequency-dependent errors, the method comprising steps of

    a) producing an analog signal through each channel (IL1-3, 101, 102), depicting a selected current/voltage quantity (22, 24.1-4), and
    b) sampling at least one analog signal (24.5) at a frequency $f_s$ being a multiple of an approximately measured frequency $f_m$, creating a base series depicting a period on the corresponding measurement channel (IL1, IL2, IL3, 101, 102),
    c) calculating from each base series obtained, values of a base frequency and a magnitude and/or a phase-angle, of at least one harmonic frequency component with the aid of a selected frequency analysis (31, 32),
    d) correcting each calculated magnitude and/or phase-angle value with the aid of a calibrated frequency-dependent function k(fn) (34) giving a frequency dependent correction value for each calculated value, in order to eliminate the said error of each measurement channel and obtaining calibrated magnitude and/or phase-angle values,
    e) calculating the selected quantities, from the calibrated magnitude and/or phase-angle values,

    **characterized in that** momentary frequency-dependent correction values are produced with a correction function for the calculation when the approximately measured frequency $f_m$ changes by more than a selected criterion.

2. Method according to Claim 1, **characterized in that** each correction function comprises a table containing discrete correction values at the selected calibration frequencies.

3. Method according to any of Claims 1 - 2, **characterized in that** the magnitude and/or phase-angle values are calculated for 7 - 64, preferably 15 - 31 harmonic frequency components.

4. Method according to any of Claims 1 - 3, **characterized in that** the said measurement range is 5 - 100 Hz, preferably 6 - 75 Hz.

5. Method according to any of Claims 1 - 4, **characterized in that** the selected analysis belongs to the group: conventional Fourier, FFT, Wavelet analysis.

6. Method according to any of Claims 1 - 5, **characterized in that** each measurement channel is also calibrated magnitudedependently.

7. Method according to any of Claims 1 - 6, **characterized in that** FFT calculation is used and the sampling frequency is set continuously relative to the measured frequency $f_m$ using the equation

$$f_s = f_m \text{ x the number of samples in the FFT buffer.}$$

8. System for measuring alternating-current quantities, which system includes

    a) an analog component (22, 24.1-4) comprising several measurement channels (IL1-3, 101, 102), each for producing an analog signal depicting a selected current/voltage quantity, and
    b) means (24.5) for sampling each analog signal at a frequency $f_s$ being a multiple of an approximately measured frequency $f_m$, creating a base series depicting a period on each measurement channel (IL1, IL2, IL3, 101, 102), and
    c) frequency-analysis means for calculating values of a base frequency and a magnitude and/or a phase-angle, of at least one harmonic frequency component from each of the base series obtained, and
    d) means (34) for correcting each calculated magnitude and/or phase-angle value with the aid of a calibrated frequency-dependent function k(fn) giving a frequency dependent correction value for each calculated value in order to eliminate the said error in each measurement channel and for obtaining calibrated magnitude and/or phase-angle values, and

e) means for calculating the selected quantities, from the calibrated magnitude and/or phase-angle values,

**characterized in that** the said correction function k(fn) comprises a correction table containing pre-calculated frequency-dependent discrete correction values stored in memory means and calculation means for performing the selected approximation according to the measured frequency.

9.  System according to Claim 8, **characterized in that** the system includes at least one measurement card (21) comprising an analog component and an A/D converter (24.5) of one measurement channel.

10. System according to Claim 9, **characterized in that** the said measurement card (21) includes the analog components of several channels and a non-volatile memory (21.1) arranged to store the calibration factors of the measurement card.

11. System according to any of Claims 8 - 10, wherein the system further includes a CPU, RAM/ROM memories, and I/O means, as well as an operating system

12. Computer program, which comprises program code to cause the system of claim 11 to execute the steps of the method according to any of Claims 1 - 7.

**Patentansprüche**

1.  Verfahren zur Messung von Wechselstromsystemgrößen durch Messkanäle, die frequenzabhängige Fehler erzeugen, wobei das Verfahren folgende Schritte umfasst:

    a) Erzeugung eines analogen Signals durch jeden Kanal (IL1-3, I01, I02), Darstellung einer ausgewählten Strom-/Spannungsgröße (22, 24.1-4), und

    b) Abtasten von mindestens einem analogen Signal (24.5) bei einer Frequenz $f_s$, die das Vielfache einer grob gemessenen Frequenz $f_m$ ist, wodurch eine Grundserie erstellt wird, die einen Abschnitt auf dem entsprechenden Messkanal (IL1, IL2, IL3, I01, I02) darstellt,

    c) Berechnung von aus jeder Grundserie erhaltenen Grundfrequenzwerten und Amplituden- und/oder Phasenwinkelwerten mindestens einer harmonischen Frequenzkomponente mittels einer ausgewählten Frequenzanalyse (31, 32),

    d) Korrektur eines jeden berechneten Amplitudenund/oder Phasenwinkelwerts mithilfe einer kalibrierten frequenzabhängigen Funktion k(fn) (34), Erteilen eines frequenzabhängigen Korrekturwerts für jeden berechneten Wert, um den besagten Fehler eines jeden Messkanals zu eliminieren und die kalibrierten Amplituden- und/oder Phasenwinkelwerte zu erhalten,

    e) Berechnung der ausgewählten Größen aus den kalibrierten Amplituden- und/oder Phasenwinkelwerten,

    **dadurch gekennzeichnet, dass** die momentanen frequenzabhängigen Korrekturwerte mit einer Korrekturfunktion für die Berechnung erzeugt werden, wenn sich die grob gemessene Frequenz $f_m$ in mehr als einem ausgewählten Kriterium ändert.

2.  Verfahren nach Anspruch 1, **dadurch gekennzeichnet, dass** zu jeder Korrekturfunktion eine Wertetabelle gehört, die diskrete Korrekturwerte für ausgewählte Kalibrierungsfrequenzen enthält.

3.  Verfahren nach einem der Ansprüche 1 - 2, **dadurch gekennzeichnet, dass** die Amplituden- und/oder Phasenwinkelwerte für 7 - 64, vorzugsweise 15 - 31 harmonische Frequenzkomponenten berechnet werden.

4.  Verfahren nach einem der Ansprüche 1 - 3, **dadurch gekennzeichnet, dass** besagter Messbereich 5 - 100 Hz, vorzugsweise 6 - 75 Hz beträgt.

5.  Verfahren nach einem der Ansprüche 1 - 4, **dadurch gekennzeichnet, dass** die ausgewählte Analyse zu folgender Gruppe gehört: klassische Fourier, FFT, Wavelet Analyse.

6.  Verfahren nach einem der Ansprüche 1 - 5, **dadurch gekennzeichnet, dass** jeder Messkanal auch amplitudenabhängig kalibriert ist.

7. Verfahren nach einem der Ansprüche 1 - 6, **dadurch gekennzeichnet, dass** FFT-Berechnung verwendet wird und die Abtastfrequenz durchgehend relativ zur gemessenen Frequenz $f_m$ eingestellt ist unter Anwendung der Formel $f_s = f_m$ x Anzahl der abgetasteten Signale im FFT-Puffer.

8. System zur Messung von Wechselstromgrößen, bestehend aus

a) einer analogen Komponente (22, 24.1-4) bestehend aus mehreren Messkanälen (IL1-3, I01, I02), jeder zur Erzeugung eines analogen Signals, das die ausgewählte Strom-/Spannungsgröße darstellt, und
b) Vorrichtungen (24.5) zum Abtasten eines jeden analogen Signals bei einer Frequenz $f_s$, die das Vielfache der grob gemessenen Freuqenz $f_m$ ist, Erstellen einer Grundserie, die einen Abschnitt auf jedem Messkanal (IL1, IL2, IL3, I01, I02) darstellt, and
c) Frequenzanalysevorrichtungen zur Berechnung von Grundfrequenzwerten und Amplituden- und/oder Phasenwinkelwerten von mindestens einer harmonischen Frequenzkomponente aus der erhaltenen Grundserie, und
d) Vorrichtungen (34) zur Korrektur eines jeden berechneten Amplituden- und/oder Phasenwinkelwerts unter Anwendung einer kalibrierten frequenzabhängigen Funktion k(fn), Ausgabe eines frequenzabhängigen Korrekturwerts für jeden berechneten Wert zur Eliminierung des besagten Fehlers in jedem Messkanal und zum Erhalten von kalibrierten Amplituden- und/oder Phasenwinkelwerten, und
e) Vorrichtungen zur Berechnung der ausgewählten Größen aus den kalibrierten Amplituden- und/oder Phasenwinkelwerten,

**dadurch gekennzeichnet, dass** zu besagter Korrekturfunktion k(fn) eine Wertetabelle gehört, welche die vorberechneten frequenzabhängigen diskreten Korrekturwerte enthält, die in Speichervorrichtungen und Berechnungsvorrichtungen abgelegt sind, um die ausgewählte grobe Schätzung entsprechend der gemessenen Frequenz auszuführen.

9. System nach Anspruch 8, **dadurch gekennzeichnet, dass** das System mindestens eine Messkarte (21) enthält, bestehend aus einer analogen Komponente und einem A/D-Wandler (24.5) eines Messkanals.

10. System nach Anspruch 9, **dadurch gekennzeichnet, dass** besagte Messkarte (21) die analogen Komponenten mehrerer Kanäle und einen nichtflüchtigen Speicher (21.1) enthält zur Speicherung der Kalibrierungsfaktoren der Messkarte.

11. System nach einem der Ansprüche 8 - 10, wobei das System auch eine CPU, RAM/ROM-Speicher und E/A-Vorrichtungen sowie ein Betriebssystem umfasst.

12. Computerprogramm, das einen Programmcode besitzt, damit das System nach Anspruch 11 die Schritte des Verfahrens nach einem der Ansprüche 1 - 7 ausführen kann.

**Revendications**

1. Procédé permettant de mesurer des quantités de systèmes de courant alternatif sur des canaux de mesure qui produisent des erreurs en fonction de la fréquence, le procédé comprenant différentes étapes dont

a) la production d'un signal analogique sur chaque canal (IL1-3, I01, I02), représentant une quantité de courant/tension choisie (22, 24.1-4), et
b) l'échantillonnage d'au moins un signal analogique (24.5) à une fréquence $f_s$, soit un multiple d'une fréquence $f_m$ mesurée approximativement, créant une série de base qui représente une période sur le canal de mesure correspondant (IL1, IL2, IL3, I01, I02),
c) le calcul, à partir de chaque série de base obtenue, de valeurs d'une fréquence de base et d'une amplitude et/ou d'un angle de phase, d'au moins une composante de fréquence harmonique à l'aide d'une analyse de fréquence choisie (31, 32),
d) la correction de chaque valeur calculée d'amplitude et/ou d'angle de phase à l'aide d'une fonction calibrée dépendant de la fréquence k(fn) (34) produisant une valeur de correction dépendant de la fréquence pour chaque valeur calculée afin d'éliminer ladite erreur de chaque canal de mesure et d'obtenir des valeurs calibrées d'amplitude et/ou d'angle de phase,

e) le calcul des quantités choisies, à partir des valeurs calibrées d'amplitude et/ou d'angle de phase,

**caractérisé en ce que** les valeurs de correction momentanées dépendant de la fréquence sont produites avec une fonction de correction pour le calcul lorsque la fréquence $f_m$ mesurée approximativement varie plus qu'un critère sélectionné.

2. Procédé conformément à la revendication 1, **caractérisé en ce que** chaque fonction de correction comprend un tableau contenant des valeurs de correction discrètes aux fréquences d'étalonnage choisies.

3. Procédé conformément à l'une quelconque des revendications 1 à 2, **caractérisé en ce que** les valeurs d'amplitude et/ou d'angle de phase sont calculées pour 7 à 64, de préférence 15 à 31, composantes de fréquences harmoniques.

4. Procédé conformément à l'une quelconque des revendications 1 à 3, **caractérisé en ce que** ladite plage de mesure se trouve entre 5 et 100 Hz, de préférence entre 6 et 75 Hz.

5. Procédé conformément à l'une quelconque des revendications 1 à 4, **caractérisé en ce que** l'analyse choisie appartient au groupe : analyse conventionnelle de Fourier, FFT, par ondelettes.

6. Procédé conformément à l'une quelconque des revendications 1 à 5, **caractérisé en ce que** chaque canal de mesure est également calibré en fonction de l'amplitude.

7. Procédé conformément à l'une quelconque des revendications 1 à 6, **caractérisé en ce que** le calcul de la FFT est utilisé et la fréquence de l'échantillonnage est définie en continu par rapport à la fréquence mesurée $f_m$ à l'aide de l'équation

$f_s = f_m$ x le nombre d'échantillons dans la mémoire tampon FFT.

8. Système permettant de mesurer des quantités de systèmes de courant alternatif, ledit système comprenant

a) une composante analogique (22, 24.1-4) comprenant plusieurs canaux de mesure (IL1-3, I01, I02), chacun pour produire un signal analogique représentant une quantité de courant/tension choisie, et

b) des moyens (24.5) d'échantillonnage de chaque signal analogique à une fréquence $f_s$, soit un multiple d'une fréquence $f_m$ mesurée approximativement, créant une série de base qui représente une période sur chaque canal de mesure (IL1, IL2, IL3, I01, I02),

c) des moyens d'analyse de la fréquence permettant de calculer des valeurs d'une fréquence de base et une amplitude et/ou un angle de phase, d'au moins une composante de fréquence harmonique de chacune des séries de base obtenues, et

d) des moyens (34) permettant de corriger chaque valeur calculée d'amplitude et/ou d'angle de phase à l'aide d'une fonction calibrée dépendant de la fréquence k(fn) produisant une valeur de correction dépendant de la fréquence pour chaque valeur calculée afin d'éliminer ladite erreur dans chaque canal de mesure, et d'obtenir des valeurs calibrées d'amplitude et/ou d'angle de phase, et

e) des moyens permettant de calculer les quantités choisies, à partir des valeurs calibrées d'amplitude et/ou d'angle de phase,

**caractérisé en ce que** ladite fonction de correction k(fn) comprend un tableau de correction contenant des valeurs de correction discrètes précalculées dépendant de la fréquence stockées sur des moyens de mémoire et des moyens de calcul pour effectuer l'approximation choisie en fonction de la fréquence mesurée.

9. Système conformément à la revendication 8, **caractérisé en ce que** le système comprend au moins une carte de mesure (21) dotée d'un composant analogique et d'un convertisseur A/D (24.5) d'un canal de mesure.

10. Système conformément à la revendication 9, **caractérisé en ce que** ladite carte de mesure (21) comprend les composantes analogiques de plusieurs canaux et une mémoire non volatile (21.1) conçues pour stocker les facteurs de calibrage de la carte de mesure.

11. Système conformément à l'une quelconque des revendications 8 à 10, où le système inclut également un processeur, des mémoires RAM/ROM et des moyens d'E/S, ainsi qu'un système d'exploitation.

12. Programme informatique, comprenant du code de programme pour permettre au système de la revendication 11 d'exécuter les étapes de la méthode conformément à l'une quelconque des revendications 1 à 7.

Fig. 1

Fig. 2

Fig. 3

Fig. 4

Fig. 5

EP 3 036 550 B1

Fig. 6

Fig. 7

Fig. 8

Fig. 9a

Fig. 9b

Fig. 10

Fig. 11

START
Subprogram - calculation of
the calibration registry

Calculating in nested loops
running indexes k and I

Fetching the frequence slot according to
the measuring frequency $f_{m,t}$ indicating index i
(upper and lower points $X_i$ ja $X_{i+1}$)

index k in range 1 - 5 (channels IL1, IL2, IL3, I01, I02)

index I in range 1 - 2 (magnitudi or angle)

Fetching calibration values $Y_{i,l,k}$ ja $Y_{i+1,l,k}$

Calculating by linear approximation $freqk_{l,k}$ =
$Y_{i,l,k}+((freq-X_{i,l,k}) * (Y_{i+1,l,k} - Y_i))/(X_{i+1,l,k}- X_i)$.

Storing $freqk_{l,k}$ in channel k, I in the instant registry

Next I (magnitude or angle)

Next k (channel)

END

Fig. 12

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5014229 A
- US 5832414 A
- US 5151866 A
- US 8108165 B2